# EUROPÄISCHE PATENTANMELDUNG

(11) **EP 3 410 000 A2**
(43) Veröffentlichungstag der Anmeldung: **05.12.2018**
(21) Anmeldenummer: 18174716.3
(22) Anmeldetag: 29.05.2018
(51) Int. Cl.: F21S 8/00, F21V 3/02, F21V 15/01, F21V 5/00

(54) **LEUCHTVORRICHTUNG**

(30) Priorität: 02.06.2017 DE 202017103332 U
(71) Anmelder: REHAU AG + Co, 95111 Rehau (DE)
(72) Erfinder: Eibl, Stefan, 95028 Hof (DE); Goldstein, Jörg, 95028 Hof (DE); Schmidt, Steven, 95182 Döhlau (DE)

(57) **Zusammenfassung**

Die vorliegende Erfindung betrifft eine Leuchtvorrichtung (100) mit einem Diffusor (1), wenigstens einer Leuchtdiode (2) zum Erzeugen von den Diffusor (1) durchstrahlenden Lichts, einem umlaufenden Rahmen (3) und einem Verschlusselement (4), wobei der Rahmen (3) einen Durchgang (5) umgrenzt, wobei ein umlaufender Randabschnitt (1a) des Diffusors (1) mit dem Rahmen (3) verbunden ist, wobei der Diffusor (1) eine umlaufende Seitenfläche (1b), eine Lichteintrittsfläche (1c) und wenigstens eine Lichtaustrittsfläche (1d) aufweist, wobei von der Leuchtdiode (2) erzeugbares Licht zum Einstrahlen in den Diffusor (1) auf die Lichteintrittsfläche (1c) des Diffusors (1) trifft, wobei wenigstens ein Mittel (6) zur Vergleichmäßigung des durch die Lichteintrittsfläche (1c) des Diffusors (1) eingestrahlten Lichts und durch die Lichtaustrittsfläche (1d) des Diffusors (1) austretenden Lichts vorgesehen ist, wobei das Verschlusselement (4) einen umlaufenden Randbereich (4a) und einen zentralen Bereich (4b) umfasst, wobei der umlaufende Randbereich (4a) mit einem umlaufenden Abschnitt (3b) des Rahmens (3) verbunden ist, und wobei die wenigstens eine Leuchtdiode (2) mit dem zentralen Bereich (4b) des Verschlusselements (4) verbunden ist.

## Beschreibung

Die vorliegende Erfindung betrifft eine Leuchtvorrichtung mit einem Diffusor.
Weiterhin betrifft die Erfindung ein Leuchtsystem mit einer solchen Leuchtvorrichtung.

Leuchtvorrichtungen dieser Art weisen meist wenigstens eine Leuchtdiode bzw. besonders bevorzugt eine Mehrzahl von Leuchtdioden zum Erzeugen von den Diffusor durchstrahlenden Lichts auf. Das den Diffusor durchstrahlende Licht wird vergleichmäßigt und in den Raum abgestrahlt.
Der Trend geht nun dahin, den Aufbau einer solchen Leuchtvorrichtung immer weiter zu vereinfachen. Hierbei wird der Ansatz verfolgt, die Leuchtdiode oder die Leuchtdioden gegenüber dem Diffusor günstig anzuordnen, um eine hohe Lichtausbeute, also Effizienz der Leuchtvorrichtung zu gewährleisten.
Eine solche Leuchtvorrichtung soll insbesondere einfach aufgebaut sein, um Kosten bei den einzelnen Komponenten, aber auch beim Zusammenbau einer solchen reduzieren zu können.

Hier setzt die Erfindung ein, deren Aufgabe es ist, eine Leuchtvorrichtung anzugeben, bei der durch wenigstens eine Leuchtdiode Licht erzeugt wird, das einen Diffusor durchstrahlt, wobei das Licht den Diffusor durch eine Lichtaustrittsfläche hindurch verlässt, welche eine hohe Lichtausbeute und Effizienz aufweist, und wobei der Aufbau der Leuchtvorrichtung einfach gehalten ist.

Die vorliegende Aufgabe wird gemäß den Merkmalen des Anspruchs 1 gelöst.

Im Rahmen der vorliegenden Erfindung wurde gefunden, dass eine Leuchtvorrichtung die gestellten Anforderungen erfüllt und die vorliegende Aufgabe löst, wenn vorgesehen ist, dass die Leuchtvorrichtung einen Diffusor und wenigstens eine Leuchtdiode zum Erzeugen von den Diffusor durchstrahlenden Lichts umfasst, weiter einen umlaufenden Rahmen und ein Verschlusselement, wobei der Rahmen einen Durchgang umgrenzt, durch den das Licht aus der Leuchtvorrichtung in den umgebenden Raum eintritt.
Ein umlaufender Randabschnitt des Diffusors ist dabei mit dem Rahmen verbunden.
Der Diffusor weist eine umlaufende Seitenfläche, eine Lichteintrittsfläche und wenigstens eine Lichtaustrittsfläche auf, wobei von der Leuchtdiode erzeugbares Licht zum Einstrahlen in den Diffusor auf die Lichteintrittsfläche des Diffusors trifft, und wobei wenigstens ein Mittel zur Vergleichmäßigung des durch die Lichteintrittsfläche des Diffusors eingestrahlten Lichts und durch die Lichtaustrittsfläche des Diffusors austretenden Lichts vorgesehen ist. Das Verschlusselement umfasst einen umlaufenden Randbereich und einen zentralen Bereich, wobei der umlaufende Randbereich mit einem umlaufenden Abschnitt des Rahmens verbunden ist, und wobei die wenigstens eine Leuchtdiode mit dem zentralen Bereich des Verschlusselements verbunden ist.
Durch das erfindungsgemäße Vorsehen, dass die wenigstens eine Leuchtdiode mit dem zentralen Bereich des Verschlusselements verbunden ist, kann die Leuchtvorrichtung im Aufbau einfach gehalten werden, wobei die Kosten bei den einzelnen Komponenten, aber auch beim Zusammenbau reduziert werden können.

In vorteilhafter Weise kann eine Vielzahl von Leuchtdioden mit dem zentralen Bereich des Verschlusselements verbunden sein.
Hierdurch ist es möglich, eine besonders hohe Lichtstärke zu realisieren, bzw. die Lichtstärke an die Notwendigkeit oder Spezifikation anzupassen.

Als sehr vorteilhaft kann sich bei der vorliegenden Erfindung ergeben, wenn vorgesehen ist, dass die wenigstens eine Leuchtdiode mit einem Tragelement mit dem zentralen Bereich des Verschlusselements verbunden ist.
Durch das Vorsehen eines Tragelements kann die wenigstens eine Leuchtdiode in einfacher und schneller Weise mit dem zentralen Bereich des Verschlusselements verbunden werden und ist dort sicher aufgenommen.

Als günstig kann sich dabei erweisen, wenn das Tragelement mehrschichtig ausgebildet ist, wobei wenigstens eine erste Schicht aus einem Polymermaterial besteht oder ein solches enthält, und eine mit der ersten Schicht verbundene zweite Schicht ein Metall ist und / oder ein solches enthält, oder ein leitfähiges Polymermaterial ist oder ein solches enthält.
Als Metall kann ausgewählt sein Silber, Gold, Zinn, Zink, Aluminium, Kupfer, Titan, Chrom, Magnesium, Eisen, Stahl, Messing, Bronze, deren mögliche Mischungen und Legierungen.

Das Metall kann in Form von Metallpartikeln und / oder Metallfäden und / oder Metallfasern vorliegen.
Die zweite Schicht kann in einer alternativen Ausgestaltung der Erfindung ein leitfähiges Polymermaterial, welches Metallpartikel und / oder Metallfäden und / oder Metallfasern enthält, aufweisen, wobei das Metall ausgewählt ist aus der Gruppe, umfassend Die zweite Schicht kann auch ein Metalloxid, wie ITO (Indium-Zinn-Oxid) oder ATO (Antimon-Zinn-Oxid) enthalten.
Als leitfähiges Polymermaterial ist ein solches geeignet, das Pulver und / oder Nanodrähte und / oder Nanopartikel aus Metall aufweist, wobei die vorstehend genannten Metalle dafür einsetzbar sind.
Auch eine Dotierung eines Polymermaterials mit einer Kohlenstoffmodifikation, wie beispielsweise Graphen oder Kohlenstoffnanotubes, wie SWCNT oder MWCNT oder Fullerene oder Graphit kann in günstiger Weise die Leitfähigkeit des Polymermaterials erhöhen.
Leitfähige Polymermaterialien, die intrinsisch leitfähig sind, können auch verwendet werden, diese sind beispielsweise PEDOT oder PEDOT:PSS oder PANI oder Polypyrrol oder Polythiophen und Polyanilin.
Die zweite Schicht kann auf der ersten Schicht als Metallschicht oder als gedruckte Leiterbahn, oder durch ein Beschichtungsverfahren, beispielsweise PVD, CVD, oder durch Plasmabeschichtungsverfahren aufgebracht sein. Das leitfähige Polymermaterial kann insbesondere auch als leitfähiger Lack oder als leitfähige Tinte aufgebracht sein.
Die zweite Schicht kann eine Schichtdicke von 5 µm bis 100 µm aufweisen.
Die erste Schicht kann eine Schichtdicke von 5 µm bis 1 mm aufweisen.
Zwischen der zweiten Schicht und der ersten Schicht kann eine Haftschicht, beispielsweise eine Kleberschicht angeordnet sein.

Ein derartiges Tragelement ist in ganz besonders praktikabler Weise geeignet, eine Leuchtdiode am zentralen Bereich des Verschlusselements anzuordnen und zu diesem eine Verbindung herzustellen.
Als vorteilhafte Ausgestaltung des Tragelements kann vorgesehen sein, das Tragelement als mehrschichtige Folie auszugestalten, wobei eine erste Schicht beispielsweise aus biaxial orientiertem Polypropylen oder aus Polyethylenterephthalat oder aus Polyethylennaphthalat besteht und eine zweite, mit der ersten Schicht verbundene Schicht aus Aluminium, die derartig strukturiert ist, dass die Leuchtdiode von einer Stromquelle oder von einer Zuleitung einer Stromquelle zu der zweiten Schicht von dieser mit Strom versorgt wird.

Hierzu kann die zweite Schicht aus Aluminium so strukturiert sein, dass Leiterbahnen ausgebildet sind, um die Leuchtdiode mit Strom zu versorgen. Die Leiterbahnen und insbesondere auch Abschnitte von Aluminium zwischen zwei Leiterbahnen können eine große Flächenausdehnung aufweisen.
Es kann auch vorgesehen sein, dass die zweite Schicht mit einem Metall und / oder einem leitfähigen Polymermaterial die Leuchtdiode mit Strom versorgt.

Sehr vorteilhaft kann sich bei der vorliegenden Erfindung ergeben, wenn die zweite Schicht zumindest abschnittsweise reflektierend ausgebildet ist.
Hierzu kann die zweite Schicht eine Oberfläche mit einem Reflexionsgrad von > 50 %, bevorzugt von > 70 % aufweisen.
Um den Reflexionsgrad der Oberfläche der zweiten Schicht zu erhöhen, kann vorgesehen sein, auf der Oberfläche eine Metallbeschichtung beispielsweise in Form einer Bedampfung (PVD) oder eine CuSn-Beschichtung aufzubringen, oder diese in einem Galvanisierverfahren abzuscheiden.
Durch das Vorsehen einer reflektierenden zweiten Schicht kann Licht, das im Inneren der Leuchtvorrichtung vagabundiert, an der reflektierenden zweiten Schicht reflektiert und so dem Diffusor zugeleitet werden.
Insbesondere die Leiterbahnen und die Abschnitte von Aluminium zwischen zwei Leiterbahnen, welche eine große Flächenausdehnung aufweisen können, können so sehr vorteilhaft das Licht reflektieren und dem Diffusor zuleiten.
Hierdurch wird die Effektivität der Leuchtvorrichtung erheblich gesteigert, da
Lichtverluste durch Absorption des aus dem Diffusor in Richtung der Innenfläche des Verschlusselements ausgekoppelten Lichts weitgehend vermieden werden.
Bei der vorliegenden Erfindung kann in einer bevorzugten Ausführung vorgesehen sein, dass zwischen einem Abschnitt des Diffusors und einem Abschnitt des Rahmens ein umlaufender flächiger Kontakt und / oder eine erste umlaufende Dichtung ausgebildet ist. Alternativ kann auch vorgesehen sein, dass ein umlaufend angeordnetes Haftmittel zwischen einem Abschnitt des Diffusors und einem Abschnitt des Rahmens ausgebildet ist.
Durch das Vorsehen der Ausbildung eines umlaufenden flächigen Kontakts und / oder einer ersten umlaufenden Dichtung zwischen einem Abschnitt des Diffusors und einem Abschnitt des Rahmens ist sichergestellt, dass an der Kontaktstelle zwischen Diffusor und Rahmen eine mediendichte Verbindung geschaffen ist, sodass weder Stoffe aus der Leuchtvorrichtung nach außen in die Umgebung, noch Stoffe von der Umgebung nach innen in die Leuchtvorrichtung an dieser Stelle austreten bzw. eindringen können.

In einer weiteren sehr bevorzugten Ausführungsform der vorliegenden Erfindung kann vorgesehen sein, dass zwischen dem Randbereich des Verschlusselements und einem Durchgangsabschnitt des Rahmens ein umlaufender flächiger Kontakt und / oder eine zweite umlaufende Dichtung ausgebildet ist.
Durch das Vorsehen eines solchen umlaufenden flächigen Kontakts und / oder einer zweiten umlaufenden Dichtung zwischen einem Randbereich des Verschlusselements und einem Durchgangsabschnitt des Rahmens ist sichergestellt, dass an dieser Stelle eine Mediendichtheit vorliegt. Dadurch können Stoffe weder aus der Leuchtvorrichtung nach außen in die Umgebung austreten, noch Stoffe aus der Umgebung in die Leuchtvorrichtung eindringen.
Durch die Dichtung, die vorzugsweise aus einem Kunststoffmaterial oder einem Gummi bzw. Gummimaterial besteht, kann vorteilhaft ein Eindringen von Fluiden über den Bereich zwischen dem Verschlusselement und dem Rahmen vermieden werden. Insbesondere kann die Dichtung stoffschlüssig mit dem Verschlusselement verbunden sein.
Das Kunststoffmaterial aus dem die Dichtung hergestellt ist, umfasst vorzugsweise thermoplastische Elastomere, welche als Homo- und / oder Copolymere vorliegen, und zwar ausgewählt aus TPO = Thermoplastische Elastomere auf Olefinbasis, TPV = Vernetzte thermoplastische Elastomere auf Olefinbasis, TPU = Thermoplastische Elastomere auf Urethanbasis, TPE-E = Thermoplastische Polyesterelastomere, TPE-S = Styrol-Blockcopolymere (SBS, SEBS, SEPS, SEEPS und MBS), TPE-A = Thermoplastische Copolyamide, z.B. PEBAX, und / oder Silikonkautschuke und / oder Polyolefinhomo- und / oder Polyolefincopolymere und / oder cyclischen Polyolefincopolymere (COC, COP) und / oder Poly-alpha-Olefin-Copolymere und / oder Polyolefinelastomere und/oder lonomere und / oder Polyvinylchlorid und/oder Polyamide und / oder Acrylatharze und / oder Acrylatcopolymere (EBA, EMA) und / oder Polyurethane und/oder Fluorhomopolymere und/oder Fluorcopolymere und/oder fluorhaltige Polyurethane.

Das umlaufend angeordnete Haftmittel kann eine Polymerschicht sein, die aus einem thermoplastischen Elastomer, welches als Homo- und / oder Copolymer vorliegt, besteht, welches ausgewählt ist aus TPO = Thermoplastische Elastomere auf Olefinbasis, TPV = Vernetzte thermoplastische Elastomere auf Olefinbasis, TPU = Thermoplastische Elastomere auf Urethanbasis, TPE-E = Thermoplastische Polyesterelastomere, TPE-S = Styrol-Blockcopolymere (SBS, SEBS, SEPS, SEEPS und MBS), TPE-A = Thermoplastische Copolyamide, z.B. PEBAX, oder aus einem Fluorhomopolymer, oder einem Fluorcopolymer, oder einem fluorhaltigen Polyurethan, oder einem Silikonkautschuk, oder einem Silikon-Urethan-Copolymer oder einem Silikon-Polyharnstoff-Copolymer, oder einem fluorhaltigen Silikonkautschuk, oder einem Polyolefinhomo- und / oder Polyolefincopolymer, oder einem cyclisches Polyolefincopolymer (COC, COP), oder einem Poly-alpha-Olefin-Copolymer, oder einem Polyolefinelastomer, oder einem lonomer, oder einem amorphen Poly-alpha-Olefin, oder einem haftungsmodifizierten Polyolefin oder Polyolefin-Copolymer, wobei haftungsmodifizierte Polyolefine mit Maleinsäureanhydrid oder Glycidylmethacrylat modifiziert sind, oder einem funktionalisiertes Polypropylen oder Polyethylen oder Ethylenvinylacetat.
Die Polyolefin-Copolymere können ausgewählt sein aus bzw. umfassen Ethylenvinylacetat oder Ethylen-Acrylatcopolymere, wie beispielsweise Ethylen-Ethylacrylat- oder Ethylen-Butylacrylat- oder Ethylen-Metylacrylat-Copolymere oder Polyvinylchlorid, oder Polyamid, oder Acrylatharz, oder Acrylatcopolymer (EBA, EMA), oder Polyurethan, oder fluorhaltige Polyurethane.
Um eine ausreichende Haftung zu erreichen, können die Fluorhomopolymere und / oder Fluorcopolymere mit Amino- und / oder Imino- und / oder Amido- und / oder Epoxy- und / oder Hydroxy- und / oder Carbonsäure- und / oder Sulfonsäure- und / oder Methacrylsäure- und / oder Maleinsäureanhydridgruppen modifiziert sein. Die Fluorhomopolymere und / oder Fluorcopolymere können aber auch dehydrofluorierte Fluorpolymere sein.

Das Haftmittel kann auch eine Klebeschicht sein, diese umfasst vorzugsweise wenigstens ein Bindemittel, ausgewählt aus bzw. aufweisend Polyvinylalkohol und / oder Polyvinylbutyral und / oder Polyvinylpyrrolidon und / oder Polyethylenvinylacetat-Copolymere und / oder Polyvinylacetat und / oder Acrylate und / oder Methacrylate und / oder Urethane und / oder Polyester und / oder Polyether und / oder Urethanacrylate und / oder Cyanmethylacrylate und / oder Cyanoethylacrylate und / oder Cyanomethylmethacrylate und / oder Cyanoethylmethacrylate und / oder (Meth)acrylsäurederivate und / oder Polymethylmethacrylate und / oder Epoxyharze und / oder Silikonkautschuke und / oder Silikonkautschukcopolymere und / oder Fluorpolymere und / oder lineare oder verzweigte Vinylhydrogenpolysiloxane und / oder Mischungen hiervon.

Wenn das Haftmittel in Form einer Klebeschicht ausgebildet ist, kann diese ein thermisch und / oder chemisch und / oder strahlenhärtendes System und / oder eine Kombination hieraus sein bzw. bilden.

Chemisch härtende Systeme umfassen Polymerisationsreaktionen und / oder Polyadditionsreaktionen und / oder Polykondensationsreaktionen und / oder Hydrosilylierungsreaktionen und / oder Vernetzungsreaktionen.
Strahlenhärtende Systeme sind insbesondere photochemisch härtende Systeme, die unter UV-Strahlung und / oder NIR-Strahlung und / oder Elektronenstrahlen und / oder Mikrowellenstrahlen aushärten.

Bei einer praktischen Ausführungsform der erfindungsgemäßen Leuchtvorrichtung ist das Verschlusselement durch eine Mehrzahl von stoffschlüssigen Verbindungen mit dem Rahmenelement stoffschlüssig verbunden.
Jede stoffschlüssige Verbindung kann z.B. als Schweißpunkt bzw. Schweißkörper oder in Form eines Klebepunkts bzw. Klebekörpers ausgebildet sein. Jede stoffschlüssige Verbindung kann z.B. dadurch realisiert sein, dass ein entsprechendes Harz oder ein Gel oder eine Dispersion oder ein Polymer bzw. eine Polymerzusammensetzung (z.B. in Form eines "Hotmelts") z.B. durch eine Walzenauftragstechnik oder eine Siebdrucktechnik oder eine Digitaldrucktechnik oder eine 3D-Drucktechnik aufgetragen ist bzw. wird.

Durch die stoffschlüssigen Verbindungen kann eine sehr stabile Verbindung zwischen dem Diffusor und dem Rahmen realisiert werden.
Die Klebstoffverbindungen können insbesondere auch voneinander beabstandet sein, wobei sie vorzugsweise gleichmäßig in dem Bereich zwischen dem Diffusor und dem Rahmen verteilt sind, einhergehend mit der Schaffung einer sehr stabilen Verbindung.

Durch die vorstehend beschriebenen Maßnahmen ist die erfindungsgemäße Leuchtvorrichtung besonders dafür geeignet, in Räumen, in denen hohe Anforderungen an die Sauberkeit und die Begrenzung von in der Luft verteilten Partikeln vorliegen, also in sogenannten "Reinräumen" eingesetzt zu werden. Ebenfalls werden durch diese Maßnahme unerwünschte Medien, beispielsweise aggressive und korrosive Gase, vom unerwünschten Eindringen in das Innere der Leuchtvorrichtung ferngehalten.
Hierzu zählen beispielsweise Anwendungen in der Medizin, wie beispielsweise in Operationsräumen, oder Anwendungen in der Lebensmittelproduktion, in der Pharmaproduktion, in der Mikroelektronik, in der Vieh- oder Tierhaltung, und andere mehr.

Mit besonders großem Vorteil kann bei der vorliegenden Erfindung vorgesehen sein, dass das Verschlusselement und der Rahmen bzw. der Rahmen und der Diffusor kraftschlüssig miteinander verbunden sind.
Durch das Vorsehen, dass das Verschlusselement und der Rahmen bzw. der Rahmen und der Diffusor kraftschlüssig miteinander verbunden sind, wird eine besonders stabile Leuchtvorrichtung geschaffen.

Die Verbindung des Verschlusselements und des Tragelements kann durch ein Haftmittel erfolgen.
Das Haftmittel kann eine Polymerschicht sein, die aus einem thermoplastischen Elastomer, welches als Homo- und / oder Copolymer vorliegt, besteht, und zwar ausgewählt aus TPO = Thermoplastische Elastomere auf Olefinbasis, TPV = Vernetzte thermoplastische Elastomere auf Olefinbasis, TPU = Thermoplastische Elastomere auf Urethanbasis, TPE-E = Thermoplastische Polyesterelastomere, TPE-S = Styrol-Blockcopolymere (SBS, SEBS, SEPS, SEEPS und MBS), TPE-A = Thermoplastische Copolyamide, z.B. PEBAX, oder ein Fluorhomopolymer, oder ein Fluorcopolymer, oder ein fluorhaltiges Polyurethan, oder ein Silikonkautschuk, oder ein Silikon-Urethan-Copolymer oder ein Silikon-Polyharnstoff-Copolymer, oder ein fluorhaltigen Silikonkautschuke, oder ein Polyolefinhomo- und / oder Polyolefincopolymer, oder ein cyclisches Polyolefincopolymeren (COC, COP), oder ein Poly-alpha-Olefin-Copolymer, oder ein Polyolefinelastomer, oder ein lonomer, oder ein amorphes Poly-alpha-Olefin, oder ein haftungsmodifiziertes Polyolefin oder Polyolefin-Copolymer, wobei haftungsmodifizierte Polyolefine mit Maleinsäureanhydrid oder Glycidylmethacrylat modifiziert sind, oder ein funktionalisiertes Polypropylen oder Polyethylen oder Ethylenvinylacetat.
Die Polyolefin-Copolymere können ausgewählt sein aus bzw. umfassen Ethylenvinylacetat oder Ethylen-Acrylatcopolymere, wie beispielsweise Ethylen-Ethylacrylat- oder Ethylen-Butylacrylat- oder Ethylen-Metylacrylat-Copolymere oder Polyvinylchlorid, oder Polyamid, oder Acrylatharz, oder Acrylatcopolymer (EBA, EMA), oder Polyurethan, oder fluorhaltige Polyurethane.
Um eine ausreichende Haftung zu erreichen, können die Fluorhomopolymere und/oder Fluorcopolymere mit Amino- und / oder Imino- und / oder Amido- und / oder Epoxy- und / oder Hydroxy- und / oder Carbonsäure- und / oder Sulfonsäure- und / oder Methacrylsäure- und / oder Maleinsäureanhydridgruppen modifiziert sein. Die Fluorhomopolymere und / oder Fluorcopolymere können aber auch dehydrofluorierte Fluorpolymere sein.

Das Haftmittel kann auch eine Klebeschicht sein, diese umfasst vorzugsweise wenigstens ein Bindemittel, ausgewählt aus bzw. aufweisend Polyvinylalkohol und / oder Polyvinylbutyral und / oder Polyvinylpyrrolidon und / oder Polyethylenvinylacetat-Copolymere und / oder Polyvinylacetat und / oder Acrylate und / oder Methacrylate und / oder Urethane und / oder Polyester und / oder Polyether und / oder Urethanacrylate und / oder Cyanmethylacrylate und / oder Cyanoethylacrylate und / oder Cyanomethylmethacrylate und / oder Cyanoethylmethacrylate und / oder (Meth)acrylsäurederivate und / oder Polymethylmethacrylate und / oder Epoxyharze und / oder Silikonkautschuke und / oder Silikonkautschukcopolymere und / oder Fluorpolymere und / oder lineare oder verzweigte Vinylhydrogenpolysiloxane und / oder Mischungen hiervon.
Wenn das Haftmittel in Form einer Klebeschicht ausgebildet ist, kann diese ein thermisch und / oder chemisch und / oder strahlenhärtendes System und / oder eine Kombination hieraus sein bzw. bilden.

Chemisch härtende Systeme umfassen Polymerisationsreaktionen und / oder Polyadditionsreaktionen und / oder Polykondensationsreaktionen und / oder Hydrosilylierungsreaktionen und / oder Vernetzungsreaktionen.
Strahlenhärtende Systeme sind insbesondere photochemisch härtende Systeme, die unter UV-Strahlung und / oder NIR-Strahlung und / oder Elektronenstrahlen und / oder Mikrowellenstrahlen aushärten.

Bei einer praktischen Ausführungsform der erfindungsgemäßen Leuchtvorrichtung ist das Verschlusselement durch eine Mehrzahl von stoffschlüssigen Verbindungen mit dem Rahmenelement stoffschlüssig verbunden.
Jede stoffschlüssige Verbindung kann z.B. als Schweißpunkt bzw. Schweißkörper oder in Form eines Klebepunkts bzw. Klebekörpers ausgebildet sein. Jede stoffschlüssige Verbindung kann z.B. dadurch realisiert sein, dass ein entsprechendes Harz oder ein Gel oder eine Dispersion oder ein Polymer bzw. eine Polymerzusammensetzung (z.B. in Form eines "Hotmelts") z.B. durch eine Walzenauftragstechnik oder eine Siebdrucktechnik oder eine Digitaldrucktechnik oder eine 3D-Drucktechnik aufgetragen ist bzw. wird.
Durch die stoffschlüssigen Verbindungen kann eine sehr stabile Verbindung zwischen dem Verschlusselement und dem Rahmen realisiert werden.
Die Klebstoffverbindungen können insbesondere auch voneinander beabstandet sein, wobei sie vorzugsweise gleichmäßig in dem Bereich zwischen dem Verschlusselement und dem Rahmen verteilt sind, einhergehend mit der Schaffung einer sehr stabilen Verbindung.

Durch diese Maßnahme ist es in einfacher Weise möglich, die erfindungsgemäße Leuchtvorrichtung an einer Decke eines Raumes oder an einer Wand eines Raumes zu befestigen, wobei die Festlegung der Leuchtvorrichtung an der Decke oder an der Wand dann wahlweise am Verschlusselement oder am Rahmen stattfinden kann.

Der Rahmen und / oder das Verschlusselement und / oder der Diffusor können in einem Formgebungsverfahren, zum Beispiel in einem Extrusionsverfahren oder einem Spritzgussverfahren oder einem Thermoformverfahren oder einem Blasverfahren oder einer Kombination der vorgenannten Verfahren hergestellt sein.
Das Verschlusselement kann planar ausgebildet sein, oder durch ein 3d-Druck-Verfahren, oder durch Tiefziehen, oder durch Pressen eine 3d-Struktur bzw. Verformungen aufweisen, wobei insbesondere auch Kavitäten ausgebildet sein können.
Im Rahmen der Erfindung liegt auch, dass ein Verbund aus dem Verschlusselement und dem Tragelement, welche ggf. 3d-verformt sind, vorliegt.
Das Tragelement kann durch Tiefziehen oder eine andere Verformungstechnik geformt sein.
Besonders bevorzugt kann das Verschlusselement zumindest abschnittsweise, insbesondere am zentralen Bereich dreidimensional geformt sein, wobei das Tragelement der dreidimensionalen Form des Verschlusselements zumindest abschnittsweise angepasst ist.

Alternativ ist es auch möglich, dass der Rahmen und / oder das Verschlusselement und / oder der Diffusor und / oder das Tragelement unter Verwendung eines generativen Fertigungsverfahrens, insbesondere einstückig, beispielsweise durch ein 3-D-Druckverfahren, hergestellt sind bzw. ist.
Hierzu kann mit Vorteil ein datenverarbeitungsmaschinenlesbares dreidimensionales Modell für die Herstellung genutzt werden.
Die Erfindung umfasst auch ein Verfahren zur Erzeugung eines datenverarbeitungsmaschinenlesbaren dreidimensionalen Modells zur Verwendung in einem Herstellungsverfahren für einen Rahmen und / oder ein Verschlusselement und / oder einen Diffusor und / oder ein Tragelement. Hierbei umfasst das Verfahren insbesondere auch die Eingabe von Daten, die einen Rahmen und / oder ein Verschlusselement und / oder einen Diffusor darstellen, in eine Datenverarbeitungsmaschine und die Nutzung der Daten, um einen Rahmen und / oder ein Verschlusselement und / oder einen Diffusor und / oder ein Tragelement als dreidimensionales Modell darzustellen, wobei das dreidimensionale Modell geeignet ist zur Nutzung bei der Herstellung eines Rahmens und / oder eines Verschlusselements und / oder eines Diffusors und / oder eines Tragelements.
Ebenfalls umfasst ist bei dem Verfahren eine Technik, bei der die eingegebenen Daten eines oder mehrerer 3D-Scanner, die entweder auf Berührung oder berührungslos funktionieren, wobei bei letzteren Energie auf einen Rahmen und / oder ein Verschlusselement und / oder einen Diffusor und / oder ein Tragelement abgegeben wird und die reflektierte Energie empfangen wird, und wobei ein virtuelles dreidimensionales Modell eines Rahmens und / oder eines Verschlusselements und / oder eines Diffusors und / oder eines Tragelements unter Verwendung einer computer-unterstützten Design-Software erzeugt wird.
Das Fertigungsverfahren kann ein generatives Pulverbettverfahren, insbesondere selektives Laserschmelzen (SLM), selektives Lasersintern (SLS), selektives Hitzesintern (Selective Heat Sintering - SHS), selektives Elektronenstrahlschmelzen (Electron Beam Melting - EBM / Electron Beam Additive Manufacturing - EBAM) oder Verfestigen von Pulvermaterial mittels Binder (Binder Jetting) umfassen. Das Fertigungsverfahren kann ein generatives Freiraumverfahren, insbesondere Auftragsschweißen, Wax Deposition Modeling (WDM), Contour Crafting, Metall-Pulver-Auftragsverfahren (MPA), Kunststoff-Pulver-Auftragsverfahren, Kaltgasspritzen, Elektronenstrahlschmelzen (Electron Beam Welding - EBW) oder Schmelzeschichtungsverfahren wie Fused Deposition Modeling (FDM) oder Fused Filament Fabrication (FFF) umfassen. Das Fertigungsverfahren kann ein generatives Flüssigmaterialverfahren, insbesondere Stereolithografie (SLA), Digital Light Processing (DLP), Multi Jet Modeling (MJM), Polyjet Modeling oder Liquid Composite Moulding (LCM) umfassen. Ferner kann das Fertigungsverfahren andere generative Schichtaufbauverfahren, insbesondere Laminated Object Modelling (LOM), 3D-Siebdruck oder die Lichtgesteuerte Elektrophoretische Abscheidung umfassen.

Bei dem Verschlusselement kann es sich besonders vorteilhaft um ein Verschlusselement handeln, das aus einem metallischen Material und / oder einem Kunststoffmaterial und / oder aus einer Mischform von metallischem Material und Kunststoffmaterial besteht. Dieses metallische Material kann ausgewählt sein aus Edelstahl, Aluminium, Magnesium, Stahl, Kupfer, Titan und Zink.
Das metallische Material kann als Metalldünnblechmaterial, das in einem Walzverfahren, ggf. unter Anwendung einer Presstechnik, hergestellt ist, eingesetzt werden.

Als Kunststoffmaterial, aus dem das Verschlusselement gebildet ist, eignen sich vorzugsweise Homo- und / oder Copolymere und / oder Mischungen von Homo- und / oder Copolymeren.
Das Kunststoffmaterial kann unvernetzt, teilweise vernetzt oder vollständig vernetzt vorliegen.
Das Kunststoffmaterial umfasst hierbei besonders bevorzugt Polyamid und / oder Polyethylenterephthalat und / oder Polybutylenterephthalat und / oder Acrylatharz und / oder Acrylatcopolymer (EBA, EMA) und / oder Polymethyl(meth)acrylat und / oder Poly(meth)acrylat und / oder Polycarbonat und / oder Blends aus Polycarbonat und Acrylester-Styrol-Acrylnitril und / oder ein Blend aus Polycarbonat und Acrylnitirl-Butadien-Styrol und / oder Polyurethan und / oder Polyolefine und / oder Polyvinylchlorid und / oder Polystyrol und / oder Polystyrol-Copolymer und / oder Methylmethacrylat-Acrylnitril-Butadien-Styrol-Copolymer und / oder Acrylester-Styrol-Acrylnitril-Copolymer und / oder Styrol-Acrylnitril-Copolymer und / oder Styrol-Methylmethacrylat-Copolymer und / oder Fluorhomopolymer und / oder Fluorcopolymer und / oder
Polyetherimid und / oder Polyamidimid und / oder Polyimid und / oder thermoplastisches Polyimid und / oder Polyphthalamid und / oder Polyketon und / oder Polyetherketon und / oder Polyetheretherketon und / oder Polyetherketonketon und / oder Polyaryletherketon und / oder Polyacetal (POM) und / oder Polyether und / oder Polyphenylenoxid und / oder Polyphenylensulfid und / oder flüssigkristallinem Polymer und / oder Polyphenylensulfon und / oder Polysulfon und / oder Polyethersulfon und / oder Polymere aus nachwachsenden Rohstoffen und / oder Hochleistungsthermoplaste.

Das Kunststoffmaterial kann insbesondere Füllstoffe wie Brand- und Flammschutzadditive, Pigmente, Glasfasern, Kohlenstofffasern, Fasern aus nachwachsenden Rohstoffen, sowie Glasbubbles, textile Gewebe, Fasergewebe, Flechtwerke, Armierungsgitter, Additive zur Erhöhung der Wärmeleitfähigkeit und anderes mehr enthalten.
Besonders bevorzugt kann es sich bei dem Verschlusselement um ein einstückiges Verschlusselement aus einem Kunststoffmaterial handeln, das vorzugsweise ein spritzgegossenes oder extrudiertes oder tiefgezogenes oder gepresstes oder thermogeformtes Verschlusselement ist.

Die flächige stoffschlüssige Verbindung zwischen einem Randbereich des Verschlusselements und einem Durchgangsabschnitt des Rahmens, die als ein umlaufender flächiger Kontakt ausgebildet ist, kann insbesondere eine Klebverbindung auf thermischer und / oder chemischer Basis oder eine Schweißverbindung sein. Sofern sowohl der Rahmen als auch das Verschlusselement aus einem Kunststoffmaterial bestehen, kann die stoffschlüssige Verbindung insbesondere auch eine Kunststoffschweißverbindung sein.
Eine solche flächig und stoffschlüssig verbindende Verbindungsschicht kann z.B. 10 µm bis 500 µm dick sein. Die Verbindungsschicht kann z.B. durch Siebdruck, mittels einer Auftragsdüse, durch Walzenauftrag oder durch Sprühen aufgebracht sein. Oder es kann eine zur Ausbildung der Verbindungsschicht vorgesehene Beschichtung bereits auf dem Randbereich des Verschlusselements vorhanden sein, wobei die Beschichtung bei der Herstellung des Verschlusselements als Coextrusionsschicht oder als Folienlaminat oder als Cospritzgussschicht vorgefertigt werden kann.
Die Verbindungsschicht kann insbesondere auch durch eine Klebefolie oder ein Klebeband realisiert werden.

Die Verbindung zwischen Rahmenelement und Verschlusselement kann auch durch das Tragelement erfolgen. Das Tragelement ist dann zumindest abschnittsweise im Überlappungsbereich zw. Verschlusselement und Rahmen angeordnet. Die Verbindung erfolgt über die erste Schicht aus Polymermaterial des Tragelements.

Die Aufgabe der vorliegenden Erfindung, ein Leuchtsystem anzugeben, erfährt ihre Lösung in Anspruch 10.
Ein Leuchtsystem mit einer Leuchtvorrichtung, wie vorstehend beschrieben, ist gegenüber solchen des Standes der Technik verbessert.

Weitere wichtige Merkmale und Vorteile der Erfindung ergeben sich aus den Unteransprüchen, aus den Figuren und aus der zugehörigen Figurenbeschreibung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Fig. dargestellt und werden in der nachfolgenden Beschreibung näher erläutert.

Hierzu zeigt:
- Fig. 1: eine schematische Querschnittsansicht eines Ausschnitts einer Leuchtvorrichtung in einer ersten Ausführungsart;
- Fig. 2: eine schematische Querschnittsansicht eines Ausschnitts einer Leuchtvorrichtung in einer zweiten Ausführungsart.

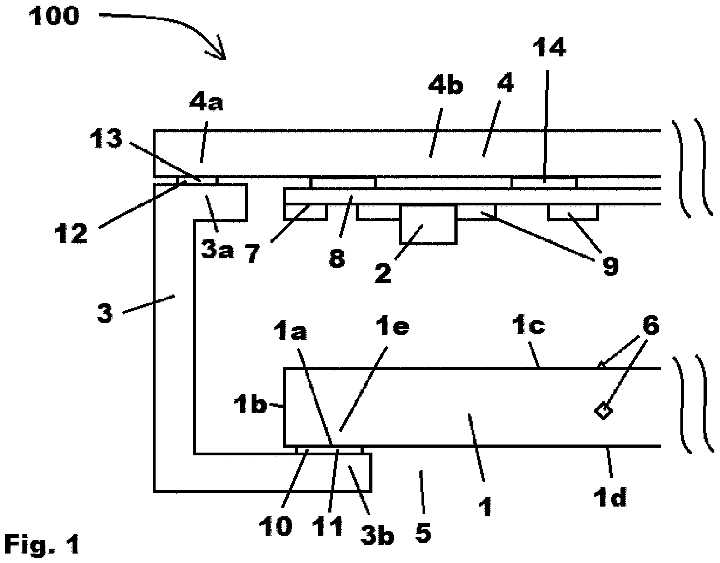

Fig. 1 zeigt eine schematische Querschnittsansicht eines Ausschnitts einer Leuchtvorrichtung 100 in einer ersten Ausführungsart.
Die Leuchtvorrichtung 100 weist einen Rahmen 3 auf.
Mit dem Rahmen 3 der Leuchtvorrichtung 100 ist ein Verschlusselement 4 verbunden, indem zwischen einem Randbereich 4a des Verschlusselements 4 und einem Abschnitt 3a des Rahmens 3 ein umlaufender flächiger Kontakt 12 und / oder eine zweite umlaufende Dichtung 13 ausgebildet ist.
Der Rahmen 3 und das Verschlusselement 4 sind solcherart fest - insbesondere kraftschlüssig - miteinander verbunden.
Der Rahmen 3 umgrenzt einen Durchgang 5, durch den das Licht, das aus der Lichtaustrittsfläche 1d des Diffusors 1 austritt, in den umgebenden Raum gelangt.
Mit dem Rahmen 3 der Leuchtvorrichtung 100 ist ein Diffusor 1 verbunden, indem zwischen einem Randabschnitt 1a des Diffusors 1 und einem Durchgangsabschnitt 3b des Rahmens 3 ein umlaufender flächiger Kontakt 10 und / oder eine erste umlaufende Dichtung 11 ausgebildet ist.
Auf diese Weise ist die erfindungsgemäße Leuchtvorrichtung 100 vollständig gekapselt, so dass diese in Räumen, in denen hohe Anforderungen an die Sauberkeit und die Begrenzung von in der Luft verteilten Partikeln vorliegen, also in sogenannten "Reinräumen" eingesetzt werden kann.
Am zentralen Bereich 4b des Verschlusselements 4 ist eine Leuchtdiode 2 angeordnet, die dort mit Hilfe eines Tragelements 7 befestigt ist.
Das Tragelement 7 ist mittels eines Haftmittels 14 an dem zentralen Bereich 4b des Verschlusselements 4 fixiert.
Das Tragelement 7 weist eine erste Schicht 8 und eine mit der ersten Schicht 8 verbundene zweite Schicht 9 auf.
Die erste Schicht 8 besteht aus einem Polymermaterial, bevorzugt aus einem Polyethylenterephthalat.

Die zweite Schicht 9 besteht aus einem Metall, bevorzugt aus Aluminium.
Die zweite Schicht 9 aus Aluminium ist derart strukturiert, dass Leiterbahnen ausgebildet sind, um die Leuchtdiode 2 mit Strom zu versorgen. Die Leiterbahnen und insbesondere auch Abschnitte von Aluminium zwischen zwei Leiterbahnen der zweiten Schicht 9 können eine große Flächenausdehnung aufweisen.
Für eine höhere Effektivität der Leuchtvorrichtung 100 sorgt eine reflektierende Oberfläche der zweiten Schicht 9 des Tragelements 7, in dem dorthin vagabundierendes Licht zum Diffusor 1 reflektiert wird.
Nicht gezeigt ist in Fig. 1, dass eine Stromversorgungsquelle da, die mit Hilfe der Leiterbahnen der zweiten Schicht 9 die Leuchtdiode 2 mit Strom versorgt.
Das von der Leuchtdiode 2 ausgesandte Licht gelangt im Wesentlichen auf direktem Weg zu der Lichteintrittsfläche 1 c des Diffusors 1.
Der Diffusor 1 weist Mittel 6 auf, um an der Lichteintrittsfläche 1c des Diffusors 1 eintretendes Licht, das von der Leuchtdiode 2 ausgesandt wird, und nach Durchstrahlung des Diffusors 1 diesen an der Lichtaustrittsfläche 1d wieder verlässt, zu vergleichmäßigen.
Solche Mittel 6 können Partikel in dem Diffusor 1 sein, an denen das Licht gestreut wird und / oder eine Oberflächenstrukturierung an der Oberfläche des Diffusors 1 an der Lichteintrittsfläche 1c und / oder an der Lichtaustrittsfläche 1d.
In der Fig. 1 sind solche Mittel 6 exemplarisch im Diffusor 1 und an der Lichteintrittsfläche 1c des Diffusors 1 gezeigt.

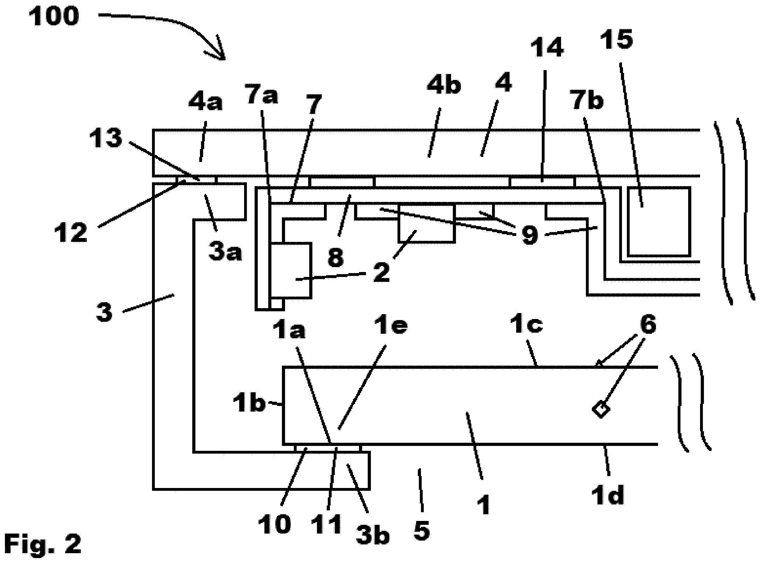

In Fig. 2 ist eine schematische Querschnittsansicht eines Ausschnitts einer Leuchtvorrichtung 100 in einer zweiten Ausführungsart gezeigt.
Die Bezugszeichen in Fig. 2 entsprechen denen aus Fig. 1.
Das Tragelement 7, welches vorliegend zwei Leuchtdioden 2 aufweist, und welches mit an einem Haftmittel 14 abschnittsweise am zentralen Bereich 4b des Verschlusselements 4 befestigt ist, weist zwei Abwinkelungen, eine erste Abwinkelung 7a und eine zweite Abwinkelung 7b auf.
Beide Abwinkelungen betragen etwa 90°.
Bei der ersten Abwinkelung 7a des Tragelements 7 ist ein Abschnitt des Tragelements 7, der auf den Abschnitt 3a des Gehäuses 3 zuweist, um etwa 90° in Richtung des Diffusors 1 abgewinkelt.
Bei der zweiten Abwinkelung 7b des Tragelements 7 ist ein Abschnitt des Tragelements 7, der vom Abschnitt 3a des Gehäuses 3 wegweist, um etwa 90° in Richtung des Diffusors 1 abgewinkelt.

Durch solche Abwinkelungen 7a, 7b kann die Effektivität der Leuchtvorrichtung 100 gesteigert werden, da dadurch beispielsweise die Anzahl der in der Leuchtvorrichtung 100 einzubauenden Leuchtdioden 2 erhöht werden kann und / oder insbesondere auch Leuchtdioden 2 verwendbar sind, die seitlich Licht aussenden.
Durch die Abwinkelungen 7a, 7b des Tragelements 7 kann in der Leuchtvorrichtung 100 Platz geschaffen werden, weitere Komponenten, wie beispielsweise ein Vorschaltgerät 15 anzuordnen, so dass dieses nicht außerhalb der Leuchtvorrichtung 100 zu platzieren ist.

### Bezugszeichenliste

- 1: Diffusor
- 1a: Randabschnitt
- 1b: Seitenfläche
- 1c: Lichteintrittsfläche
- 1d: Lichtaustrittsfläche
- 2: Leuchtdiode
- 3: Rahmen
- 3a: Abschnitt
- 3b: Durchgangsabschnitt
- 4: Verschlusselement
- 4a: Randbereich
- 4b: zentraler Bereich
- 5: Durchgang
- 6: Mittel
- 7: Tragelement
- 7a: erste Abwinkelung
- 7b: zweite Abwinkelung
- 8: erste Schicht
- 9: zweite Schicht
- 10: Kontakt
- 11: erste umlaufende Dichtung
- 12: Kontakt
- 13: zweite umlaufende Dichtung
- 14: Haftmittel
- 15: Vorschaltgerät
- 100: Leuchtvorrichtung
- 200: Leuchtsystem

## Patentansprüche

1. Leuchtvorrichtung (100) mit einem Diffusor (1), wenigstens einer Leuchtdiode (2) zum Erzeugen von den Diffusor (1) durchstrahlenden Lichts, einem umlaufenden Rahmen (3) und einem Verschlusselement (4), wobei der Rahmen (3) einen Durchgang (5) umgrenzt, wobei ein umlaufender Randabschnitt (1a) des Diffusors (1) mit dem Rahmen (3) verbunden ist, wobei der Diffusor (1) eine umlaufende Seitenfläche (1b), eine Lichteintrittsfläche (1c) und wenigstens eine Lichtaustrittsfläche (1d) aufweist, wobei von der Leuchtdiode (2) erzeugbares Licht zum Einstrahlen in den Diffusor (1) auf die Lichteintrittsfläche (1c) des Diffusors (1) trifft, wobei wenigstens ein Mittel (6) zur Vergleichmäßigung des durch die Lichteintrittsfläche (1c) des Diffusors (1) eingestrahlten Lichts und durch die Lichtaustrittsfläche (1d) des Diffusors (1) austretenden Lichts vorgesehen ist, wobei das Verschlusselement (4) einen umlaufenden Randbereich (4a) und einen zentralen Bereich (4b) umfasst, wobei der umlaufende Randbereich (4a) mit einem umlaufenden Abschnitt (3b) des Rahmens (3) verbunden ist, und wobei die wenigstens eine Leuchtdiode (2) mit dem zentralen Bereich (4b) des Verschlusselements (4) verbunden ist.

2. Leuchtvorrichtung (100) nach Anspruch 1, **dadurch gekennzeichnet, dass** die wenigstens eine Leuchtdiode (2) mittels eines Tragelements (7) mit dem zentralen Bereich (4b) des Verschlusselements (4) verbunden ist.

3. Leuchtvorrichtung (100) nach Anspruch 2, **dadurch gekennzeichnet, dass** das Tragelement (7) mehrschichtig ausgebildet ist, wobei wenigstens eine erste Schicht (8) aus einem Polymermaterial besteht oder ein solches enthält, und eine mit der ersten Schicht (8) verbundene zweite Schicht (9) ein Metall ist und / oder ein solches enthält, oder ein leitfähiges Polymermaterial ist oder ein solches enthält.

4. Leuchtvorrichtung (100) nach Anspruch 3, **dadurch gekennzeichnet, dass** die zweite Schicht (9) mit einem Metall und / oder einem leitfähigen Polymermaterial die Leuchtdiode (2) mit Strom versorgt.

5. Leuchtvorrichtung (100) nach einem der Ansprüche 3 oder 4, **dadurch gekennzeichnet, dass** die zweite Schicht (9) zumindest abschnittsweise reflektierend ausgebildet ist.

6. Leuchtvorrichtung (100) nach einem der vorangehenden Ansprüche, **dadurch gekennzeichnet, dass** zwischen einem Abschnitt (1e) des Diffusors (1) und einem Abschnitt (3a) des Rahmens (3) ein umlaufender flächiger Kontakt (10) und / oder eine erste umlaufende Dichtung (11) ausgebildet ist.

7. Leuchtvorrichtung (100) nach einem der vorangehenden Ansprüche, **dadurch gekennzeichnet, dass** zwischen einem Randbereich (4a) des Verschlusselements (4) und einem Durchgangsabschnitt (3b) des Rahmens (3) ein umlaufender flächiger Kontakt (12) und / oder eine zweite umlaufende Dichtung (13) ausgebildet ist.

8. Leuchtvorrichtung (100) nach einem der vorangehenden Ansprüche, **dadurch gekennzeichnet, dass** das Verschlusselement (4) und der Rahmen (3) kraftschlüssig miteinander verbunden sind.

9. Leuchtvorrichtung (100) nach einem der vorangehenden Ansprüche, **dadurch gekennzeichnet, dass** das Verschlusselement (4) zumindest abschnittsweise, insbesondere am zentralen Bereich (4b) dreidimensional geformt ist, wobei das Tragelement (7) der dreidimensionalen Form des Verschlusselements (4) zumindest abschnittsweise angepasst ist.

10. Leuchtsystem (200) mit einer Leuchtvorrichtung (100) nach einem Ansprüche 1 bis 9.
